# EUROPEAN PATENT APPLICATION

(11) **EP 0 926 686 A1**
(43) Date of publication of application: **30.06.1999**
(21) Application number: 97830697.5
(22) Date of filing: 23.12.1997
(51) Int. Cl.: G11C 16/04

(54) **Non-volatile, serial-flash, EPROM, EEPROM and flash-EEPROM type memory in AMG configuration**

(71) Applicant: STMicroelectronics S.r.l., 20041 Agrate Brianza (Milano) (IT)
(72) Inventor: Zatelli, Nicola, 24123 Bergamo (IT)
(74) Representative: Cerbaro, Elena

(57) **Abstract**

The non-volatile memory comprises a MOS selection transistor (40) having an input terminal (41) receiving a first voltage (V_{IN}), an output terminal (42) supplying a second voltage (V_{OUT}), a control terminal (43) receiving a third voltage (V_{G}) and a bulk region (52) housing conductive regions (53, 54) connected to the input and output terminals. The selection transistor (40) is a P-channel transistor and the bulk region (52) is biased at a fourth voltage (V_{B}) not less than the first voltage (V_{IN}).

## Description

The invention relates to a non-volatile serial-flash, EPROM, EEPROM and flash-EEPROM memory in AMG (Alternate Metal Ground) configuration.

As known, in non-volatile memories of the above-mentioned type an N-channel selection transistor is present which is placed in series with a bit line to which a plurality of EEPROM memory cells is connected or is placed in series with an EEPROM memory element. In particular, in case of serial-flash memories, the selection transistor acts as a selector to enable a partition of the memory matrix, in flash-EEPROM memories in AMG configuration and in EPROM memories the selection transistor belongs to the column decoder that allows biasing at preset potentials of the addressed column.

In selection transistors, particularly during cell programming and erasing (in which a high voltage, such as 14 V, is required at the output terminal of the selection transistor - source terminal), the input voltage of the selection transistor has to be considerably higher than the output voltage. In fact, the output voltage is given by the input voltage minus a quantity that is approximately equal to the threshold voltage. On the other hand, it is also known that the threshold voltage of MOS transistors depends on the voltage drop existing between transistor bulk and source regions (so-called "body effect"). In N-channel selection transistors currently in use, the bulk of the transistor (of P type) is generally formed by the substrate itself and its potential is close to ground. Consequently, there is a high voltage drop between the source region and the bulk, which gives rise in turn to a high threshold voltage and thus requires supply to the input terminal of the selection transistor of a voltage that is higher than the required output voltage (approx. 16-17 V in the example quoted above).

On the other hand, generation and transfer of voltages as high as this are complex in that they require an appropriate pumping circuit on the one hand and on the other hand they involve the use of manufacturing processes for components for high voltage, with a high breakdown voltage.

The object of the invention is therefore to provide a non-volatile memory which solves the above problem.

The invention provides a non-volatile serial-flash, EPROM, EEPROM and flash-EEPROM memory in AMG configuration, as defined in Claim 1.

For an understanding of the invention, a preferred embodiment will now be described, purely by way of non-exhaustive example, with reference to the accompanying drawings in which:
- Figure 1 shows a simplified diagram relating to a flash EEPROM or EPROM memory of known type;
- Figure 2 shows a simplified diagram relating to a serial-flash memory of known type;
- Figure 3 shows the simplified circuit diagram of an EEPROM memory;
- Figure 4 shows a portion of a memory including a selection transistor according to the invention; and
- Figure 5 shows a cross-section through a semiconductor material wafer comprising selection transistor of Figure 4.

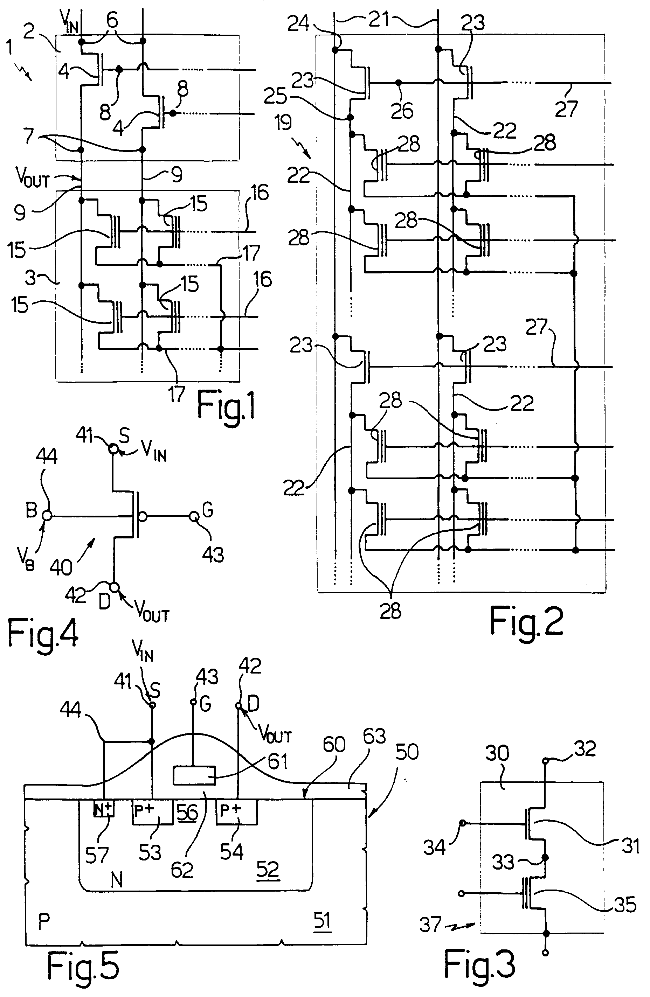

Figure 1 shows a simplified diagram of a non-volatile memory 1 of flash-EEPROM or EPROM type; only those elements thereof which are essential to an understanding of the invention are shown in diagrammatic form. In detail, the memory 1 comprises a column decoder 2 and a memory array 3; the column decoder 2 comprises a plurality of N-channel selection transistors 4 having an input terminal 6 (drain) forming the input to which the input voltage V_{IN} is supplied; an output terminal 7 (source) connected to a respective bit line 9 to which the voltage V_{OUT} is supplied; and a control terminal 8 (gate) for turning on the sole selection transistor. In turn the memory array 3 comprises a plurality of memory cells 15, having drain terminal connected to a respective bit line 9, gate terminal connected to a word line 16 and source terminal connected to a respective source line 17.

Figure 2 shows the simplified diagram of a serial-flash memory 19, in which the memory array 20 comprises a plurality of global bit lines 21 each connected to a plurality of local bit lines 22 through a respective N-channel selection transistor 23. Each selection transistor 23 has an input terminal 24 connected to a respective global bit line 21, an output terminal 25 connected to a respective local bit line 22 and a control terminal 26 connected to a respective selection line 27. Selection transistors 23 located on the same column are connected to the same global bit line 21 and each control an own local bit line 22; selection transistors 23 located on the same row are connected to the same selection line 27. Memory cells 28 are connected to the local bit lines.

Figure 3 shows a circuit diagram of a cell 30 belonging to an EEPROM memory 37 and comprising a selection transistor 31, having an input terminal 32, an output terminal 33 and a control terminal 34; the selection transistor 31 is placed in series with a memory element denoted by 35.

As explained above, in the diagrams shown in Figures 1-3 selection transistors 4, 23, 31 must be supplied at input terminal 6, 24, 32 with a voltage substantially higher than that required by bit lines 9, 22 or at terminal 33, because of the body effect.

To solve this problem, as shown in Figure 4, the selection transistor, denoted by 40, is a P-channel one and is biased such that the N-type well, wherein the conductive source and drain regions are formed, is placed at a potential not less than that of the source region. P-channel selection transistor 40 thus replaces selection transistors 4, 23 and 31 of Figs. 1, 2 and 3 and has an input terminal 41 (source) receiving the voltage V_{IN}, an output terminal 42 (drain) supplying the voltage V_{OUT}, a control terminal 43 (gate) biased at voltage V_{G}, and respectively corresponding to input terminals 6, 24, 32; to output terminals 7, 25, 33 and to control terminals 8, 26, 34. If selection transistor 40 is used in EEPROM memory 37 of Figure 3 in place of selection transistor 31, various memory elements 35 may be connected to output terminal 33 to reduce the desired dimensions. Furthermore, P-channel selection transistor 40 has a bulk terminal 44 which allows direct biasing of well region at a potential V_{B}, as described in greater detail below.

Figure 5 shows a physical implementation of P-channel selection transistor 40 in a single-crystal silicon wafer 50 comprising a P-type substrate 51, housing an N-type well 52, housing in its turn a source region 53 and a drain region 54, both P⁺-type, defining between them a channel region 56 formed by well 52. Inside well 52 is further provided a contact region 57, N⁺-type, for independently biasing well 52. In per se known manner, a control gate region 61, electrically isolated from wafer 50 by a gate oxide region 62 and surrounded by an isolating region 63 of dielectric material, is present on top of surface 60 of wafer 50. Figure 5 further shows terminals 41-44 defining the electrodes for connection to respective regions 53, 54, 61 and 44; source terminal 41 and bulk terminal 44 are also connected together.

By biasing well 52 at least at the same potential as source region 53, the drop between source region 53 and drain region 54 becomes equal to the sole threshold voltage of P-channel selection transistor 40 which is much reduced (typically 200 mV) in saturation state. Furthermore, the diode formed between source region 53 and well 52 is off and does not cause problems. Consequently, virtually the voltage desired at the output terminal (drain) may be supplied to the input terminal (source) of P-channel selection transistor 40 and V_{IN} approximately equals V_{OUT}. This voltage may be between 7 and 15 V, for example, depending on the memory type and process used.

With the shown configuration, in programming, gate region 61 must be biased at a non-positive voltage V_{G}, such as -2 V; this biasing does not, however, create problems for the type of memories in question.

The advantages of the described solution will clearly emerge from the above. In fact, use of a P-channel selection transistor biased in the manner shown enables voltages approximately equal to those required at the output (on the bit lines) to be supplied at the input, eliminating the need of voltages higher than operating voltages, and circuit components with particularly high strength properties. The solution is simple and reliable and does not require any modification of standard process steps, since it requires formation of regions which generally already have to be provided also in other zones of the memory. It does not therefore involve a substantial increase in costs. Furthermore, with the cited biasing, the diode existing between well 52 and source region 53 can be reliably prevented from moving into a direct conduction zone.

Finally it will be clear that many modifications and variants may be introduced to the memory described and illustrated herein, all of which come within the scope of the invention as defined in the accompanying claims. In particular, it is emphasized that biasing of well 52 does not necessarily have to be equal to that of the source region, though that solution is advantageous to have a single biasing voltage for both regions; the solution shown is applicable to all non-volatile memories with N-channel selection transistor which are required, at least in some operating states of the memory, to transfer high voltages and which are subject to the body effect.

## Claims

1. A non-volatile serial-flash, EPROM, EEPROM and flash-EEPROM memory (1; 19; 37) in AMG configuration, comprising a MOS selection transistor (40) having an input terminal (41) receiving a first voltage (V_{IN}), an output terminal (42) supplying a second voltage (V_{OUT}), a control terminal (43) receiving a third voltage (V_{G}) and a bulk region (52) housing conductive regions (53, 54) connected to said input and output terminals, characterized in that said selection transistor (40) is a P-channel transistor and in that said bulk region (52) is biased at a fourth voltage (V_{B}) not less than said first voltage (V_{IN}).

2. A memory according to Claim 1, characterized in that said first terminal (41) is a source terminal, said second terminal (42) is a drain terminal and said control terminal (43) is a gate terminal.

3. A memory according to Claim 1 or 2, characterized in that said fourth voltage (V_{B}) is equal to said first voltage (V_{IN}).

4. A memory according to any one of the preceding Claims, characterized in that, at least in an operating state of the memory, said first voltage (V_{IN}) is between 7 and 15 V and said third voltage (V_{G}) is not greater than 0 V.

5. A memory according to Claim 4, characterized in that said third voltage (V_{G}) is approximately -2 V in said operating state.

6. A memory according to any one of the preceding Claims, characterized in that said selection transistor (40) is formed in a wafer (50) of semiconductor material comprising a P-type substrate (51) housing an N-type well (52) defining said bulk region and in turn housing a first and a second conductive region (53, 54) of P type which face a wafer surface (60), are reciprocally spaced apart and between them define a channel region (56) formed by said well.

7. A memory according to Claim 6, characterized in that said first conductive region (53) is connected to said first terminal (41), said second conductive region (54) is connected to said second terminal (42) and said well (52) is electrically connected to said first conductive region (53).
